# EUROPEAN PATENT SPECIFICATION

(11) **EP 0 926 814 B1**
(45) Date of publication and mention of the grant of the patent: **20.02.2002**
(21) Application number: 97830696.7
(22) Date of filing: 23.12.1997
(51) Int. Cl.: H03F 1/00, H03H 11/04

(54) **Feedforward structure with programmable zeros for synthesizing continuous-time filters, delay lines and the like**
Vorwärtsgekoppelte Struktur mit programmierbaren Nullstellen zur Synthese von zeitkontinuierlichen Filtern, Verzögerungsleitungen und dergleichen
Structure à action anticipée avec zéros programmables pour la synthèse de filtres à temps continu, lignes à retard et similaires

(43) Date of publication of application: 30.06.1999
(73) Proprietor: STMicroelectronics S.r.l., 20041 Agrate Brianza (Milano) (IT)
(72) Inventor: Portaluri, Salvatore, 27100 Pavia (IT); Pisati, Valerio, 27040 Bosnasco (Pavia) (IT)
(74) Representative: Modiano, Guido, Dr.-Ing.

(56) References cited:
- EP-A- 0 696 846
- DE-A- 4 113 244
- VAINIO O ET AL: "A CLASS OF ACTIVE-RC FILTERS WITH PREDICTIVE CHARACTERISTICS" PROCEEDINGS OF THE INSTRUMENTATION AND MEASUREMENT TECHNOLOGY CONFERENCE, WALTHAM, MA., APR. 23 - 26, 1995, 23 April 1995, INSTITUTE OF ELECTRICAL AND ELECTRONICS ENGINEERS, pages 358-363, XP000534876

## Description

The present invention relates to a feedforward structure with programmable zeros for synthesizing continuous-time filters, delay lines and the like. More particularly, the invention relates to a feedforward structure with programmable zeros for providing programmable delay cells.

It is known that the frequency response of an amplified signal entails a correlation between the frequency response of the amplitude (modulus) of the signal and the frequency response of the phase of said signal. In particular, as the band increases, the phase changes and therefore the group delay is reduced. Group delay is defined as the derivative of the phase with respect to the frequency.

Theoretically, the desirable result is a programmable delay with an infinite band.

In applications in which it is necessary to have a delay which can be programmed according to requirements while maintaining a wide signal band, this last requirement cannot be achieved by means of conventional circuits.

In particular, conventional circuits designed to provide the above conditions resort to operational-amplifier structures which require the use of control loops, with high orders of filtering, high consumption and large areas for their implementation.

In conventional structures of the fedback type, derivative signals are introduced in high-frequency points of the circuit, introducing zeros in the transfer function, with the above-described drawbacks.

The aim of the present invention is to provide a feedforward structure with programmable zeros for synthesizing continuous-time filters, delay lines and the like, which allows to widen the band of the signal without distorting group delay appreciably.

Within the scope of this aim, an object of the present invention is to provide a feedforward structure with programmable zeros for synthesizing continuous-time filters, delay lines and the like which allows to obtain a programmable delay while maintaining a wide signal band.

Another object of the present invention is to provide a feedforward structure with programmable zeros for synthesizing continuous-time filters, delay lines and the like which allows frequency amplification of the modulus of a signal without altering its phase response.

Another object of the present invention is to provide a feedforward structure with programmable zeros for synthesizing continuous-time filters, delay lines and the like in which said structure is obtained in an open-loop mode.

Another object of the present invention is to provide a feedforward structure with programmable zeros for synthesizing continuous-time filters, delay lines and the like having low current consumption and reduced area occupation.

Another object of the present invention is to provide a feedforward structure with programmable zeros for synthesizing continuous-time filters, delay lines and the like which is highly reliable and relatively easy to manufacture at low costs.

This aim, these objects and others which will become apparent hereinafter are achieved by a feedforward structure with programmable zeros for synthesizing continuous-time filters, delay lines and the like, characterized in that it comprises a first cell and a second cell which are cascade-connected, each one of said first and second cells comprising a first pair of bipolar transistors in which the emitter terminals are connected to a current source, said first pair of transistors being connected to a second pair of transistors, a current source being connected to the emitter terminals of said second pair of transistors, a first high-impedance element being connected between said first and second pairs of transistors, a second high-impedance element being connected in output to said second pair of transistors, a fifth transistor being connected between the collector terminal of a first transistor of said first pair of transistors and a collector terminal of a second transistor of said second pair of transistors, the base terminal of said fifth transistor receiving a signal which is taken from the collector terminal of said first transistor of the first pair of transistors, said signal being taken with a positive sign in said first cell and with a negative sign in said second cell, in order to determine a transfer function with a pair of singularities at the numerator, the second transistors of said first and second pairs being controlled respectively by current sources which have mutually different values.

Further characteristics and advantages of the invention will become apparent from the description of preferred but not exclusive embodiments of the feedforward structure according to the invention, illustrated only by way of non-limitative example in the accompanying drawings, wherein:
Figure 1 is a circuit diagram of a first embodiment of the feedforward structure according to the present invention; and
Figure 2 is a circuit diagram of a second embodiment of the feedforward structure according to the present invention.

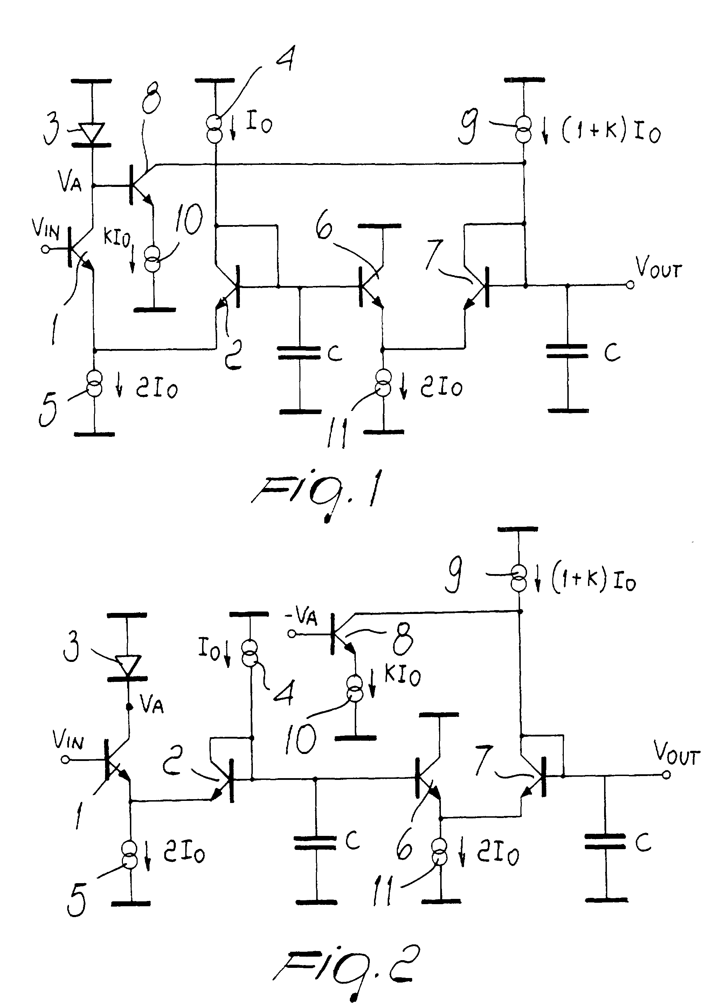

With reference to the above figures, the feedforward structure according to the present invention is illustrated in Figure 1 as regards the provision of a singularity (zero) in the left half-plane and in Figure 2 as regards the provision of a singularity (zero) in the right half-plane.

The circuit of Figure 1 comprises a first circuit section and a second circuit section which are mutually connected.

The first circuit section comprises a first bipolar transistor 1, whose base terminal receives an input signal Vin.

A diode (3) and a first current source 4 are respectively connected to the collector terminals of the pair of bipolar transistors 1 and 2; the first current source 4 supplies a current I₀. The emitter terminals of the transistors 1 and 2 are then connected to a second current source 5.

A first capacitor C is connected to the base terminal of the bipolar transistor 2.

The second circuit section comprises a second pair of bipolar transistors, which are referenced to as third transistor 6 and fourth transistor 7.

In the third bipolar transistor 6, the base terminal is connected to the base terminal of the transistor 2 and the collector terminal is connected to the supply voltage.

The emitter terminals of the transistors 6 and 7 are biased by a third current source 11 whose value is equal to the second current source.

The bipolar transistor 7 is diode-connected, and a second capacitor C, for example equal in value to the first capacitor, is connected to the base terminal of said transistor.

A fourth current source 9, whose value is (1+K) times the value of the first current source 4, is connected to the common node between the base terminal and the collector terminal of the transistor 7.

Finally, a fifth bipolar transistor 8 is connected, by means of its base terminal, to the collector terminal of the transistor 1 and, by means of its collector terminal, to the common node between the base terminal and the collector terminal of the bipolar transistor 7, thus providing an additional connection between the first and second circuit sections.

A fifth current source 10 is connected to the emitter terminal of the bipolar transistor 8 and its value is K times the value of the first current source 4.

In Figure 2, identical reference numerals designate identical elements.

The difference between the circuit of Figure 1 and the circuit of Figure 2 resides in the fact that the fifth bipolar transistor 10 receives in input a signal which is taken from the collector terminal of the bipolar transistor 1, with its sign changed.

In this manner, the transfer function of the circuit of Figure 1 is given by:${\text{H1(s) = Vout/Vin = (1 + sK/W}}_{\text{0}} {\text{) / (1 + s/W}}_{\text{0}} {\text{)}}^{\text{2}}$ while the transfer function of the circuit of Figure 2 is given by:${\text{H2(s) = Vout/Vin = (1 - sK/W}}_{\text{0}} {\text{) / (1 + s/W}}_{\text{0}} {\text{)}}^{\text{2}}$

The global transfer function of the two above-described cells, which are cascade-connected and shown respectively in Figures 1 and 2, is thus given by the product of the two transfer functions H1(s) and H2(s). It is thus possible to obtain:${\text{H(s) = [1 - (Ks/W}}_{\text{0}} {\text{)}}^{\text{2}} {\text{] / (1 + S/W}}_{\text{0}} {\text{)}}^{\text{4}}$

This transfer function produces a pair of real zeros which are arranged respectively in the left half-plane and in the right half-plane if the value of K is chosen equal for the circuit of Figure 1 and for the circuit of Figure 2.

Otherwise, if one chooses K = K1 and K = K2, with K1 different from K2, then the resulting transfer function has a term in "s" at the numerator and is of the 1+βs-alpha s² type.

In practice, it has been observed that the structure according to the invention fully achieves the intended aim and objects, since it allows, by means of a simple cascade connection of two cells, to obtain a transfer function with two real zeros. In this case, the group delay remains flat for the band of interest of the signal.

If the transfer functions of the two cells provided according to the present invention are instead obtained so that their respective numerators have mutually different terms in K, i.e., so that K=K1 for a first transfer function and K=K2 for a second transfer function, it is possible to obtain a global transfer function (determined by the product of the transfer functions of the two cascade-connected cells) wherein a polynomial of the 1+βs-alpha s² is present at the numerator.

In this second case, by varying the terms K1 and K2 it is possible to have a preset variation of the group delay without varying the band of the signal.

The feedforward structure thus conceived is susceptible of numerous modifications and variations, all of which are within the scope of the inventive concept.

Thus, for example, the capacitors C of the two cells can be chosen so as to have mutually different values.

Finally, all the details may be replaced with other technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A feedforward structure with programmable zeros for synthesizing continuous-time filters, delay lines and the like, **characterized in that** it comprises a first cell (Fig 1) and a second cell (Fig 2) which are cascade-connected, each one of said first and second cells comprising a first pair (1, 2) of bipolar transistors in which the emitter terminals are connected to a current source (5), said first pair of transistors being connected to a second pair (6, 7) of transistors, a current source (11) being connected to the emitter terminals of said second pair of transistors, a first high-impedance element (C) being connected between said first and second pairs of transistors, a second high-impedance element (C) being connected in output to said second pair of transistors, a fifth transistor (8) being connected between the collector terminal of a first transistor (1) of said first pair of transistors and a collector terminal of a second transistor (7) of said second pair of transistors, the base terminal of said fifth transistor receiving a signal which is taken from the collector terminal of said first transistor of the first pair of transistors, said signal being taken with a positive sign in said first cell and with a negative sign in said second cell, in order to determine a transfer function with a pair of singularities at the numerator, the second transistors (2, resp. 7) of said first and second pairs being controlled respectively by current sources (4, resp. 9) which have mutually different values.

2. A feedforward structure according to claim 1, **characterized in that** the current sources of said second transistors of said first and second pairs of transistors are connected to the collector terminals of said second transistors.

3. A feedforward structure according to claim 1, **characterized in that** said second transistors of said first and second pairs of transistors are diode-connected.

4. A feedforward structure according to claim 2, **characterized in that** said fifth transistor has a current source connected to its emitter terminal.

5. A feedforward structure according to claim 4, **characterized in that** said current source connected to the emitter terminal of said fifth transistor has a value equal to K times the value of the current source connected to the collector terminal of said second transistor of the first pair of transistors.

6. A feedforward structure according to claim 1, **characterized in that** the current sources that control the second transistors of said first pair of transistors and of said second pair of transistors are connected to the collector terminals of said second terminals, the value of the current source of said second pair of transistors being equal to (1+K) times the value of the current source of said first pair of transistors.

7. A cell with feedforward structure having programmable zeros, **characterized in that** it comprises a first pair (1, 2) of bipolar transistors and a second pair (6, 7) of bipolar transistors which are mutually connected with a first high-impedance element (C) interposed, a second high-impedance element (C) being provided at the output of said second pair of transistors, a further transistor (4 Fig 1, 8 Fig 2) being connected between a first transistor of said first pair and a second transistor of said second pair.

8. A cell with feedforward structure according to claim 7, **characterized in that** in said further transistor the base terminal is connected to the collector terminal of said first transistor of the first pair of transistors and the collector terminal is connected to the collector terminal of the second transistor of said second pair of transistors.

9. A cell with feedforward structure according to claim 8, **characterized in that** a signal taken from the collector terminal of said first transistor of the first pair of transistors is input to the base terminal of said further transistor.

10. A cell with feedforward structure according to claim 8, **characterized in that** a signal taken from the collector terminal of said first transistor of the first pair of transistors is input, with its sign changed, to the base terminal of said further transistor.

11. A cell with feedforward structure according to claim 7, **characterized in that** current sources are respectively connected to the collector terminals of said second transistors of the first and second pairs of transistors, the value of the current source connected to the second transistor of said second pair being equal to (1+K) times the value of the current source connected to the second transistor of said first pair.

12. A cell with feedforward structure according to claim 1, **characterized in that** a current source having a value which is K times the value of the current source connected to the collector terminal of the second terminal of said first pair of transistors is connected to the emitter terminal of said further transistor.

## Patentansprüche

1. Vorwärtsgekoppelte Struktur mit programmlerbaren Nullstellen zum Synthetlsieren von zeitkontinuierlichen Filtern, Verzögerungsleitungen und dergleichen,
**dadurch gekennzeichnet, dass** sie aufweist: eine erste Zelle (Fig. 1) und eine zweite Zelle (Fig. 2), die stufengekoppelt sind, wobei jede dieser ersten und zweiten Zellen ein erstes Paar (1, 2) von bipolaren Transistoren aufweist, bei denen die Emitteranschlüsse mit einer Stromquelle (5) verbunden sind, wobei das erste Paar von Transistoren mit einem zweiten Paar (6, 7) von Transistoren verbunden ist, eine Stromquelle (11), die mit den Emitteranschlüssen des zweiten Paars von Transistoren verbunden ist, ein erstes Hochimpedanzelement (C), das zwischen das erste und das zweite Paar von Transistoren geschaltet ist, ein zweites Hochimpedanzelement (C), das an den Ausgang des zweiten Paars von Transistoren geschaltet ist, ein fünfter Transistor (8), der zwischen den Kollektoranschluss eines ersten Transistors (1) des ersten Paars von Transistoren und einen Kollektoranschluss eines zweiten Transistors (7) des zweiten Paars von Transistoren geschaltet ist, wobei der Basisanschluss des fünften Transistors ein Signal empfängt, das von dem Kollektoranschluss des fünften Transistors des ersten Paars von Transistoren abgegriffen wird, wobei dieses Signal mit einem positiven Vorzeichen in dieser ersten Zelle und mit einem negativen Vorzeichen In dieser zweiten Zelle abgegriffen wird, um eine Transferfunktion mit einem Paar von Singularitäten im Zähler zu bestimmen, wobei die zweiten Transistoren (2 bzw. 7) des ersten und zweiten Paars jeweils durch Stromquellen (4 bzw. 9) gesteuert werden, die beiderseits verschiedene Werte haben.

2. Vorwärtsgekoppelte Struktur nach Anspruch 1,
**dadurch gekennzeichnet, dass** die Stromquellen des zweiten Transistors des ersten und zweiten Paars von Transistoren mit den Kollektoranschlüssen der zweiten Transistoren verbunden sind.

3. Vorwärtsgekoppelte Struktur nach Anspruch 1,
**dadurch gekennzeichnet, dass** die zweiten Transistoren der ersten und zweiten Paare von Transistoren diodengekoppelt sind.

4. Vorwärtsgekoppelte Struktur nach Anspruch 2,
**dadurch gekennzeichnet, dass** der fünfte Transistor mit seinem Emitteranschluss mit einer Stromquelle verbunden ist.

5. Vorwärtsgekoppelte Struktur nach Anspruch 4,
**dadurch gekennzeichnet, dass** diese Stromquelle, die mit dem Emitteranschluss des fünften Transistors verbunden ist, einen Wert hat, der dem K-fachen des Wertes der Stromquelle entspricht, die mit dem Kollektoranschluss des zweiten Transistors des ersten Paars von Transistoren verbunden ist.

6. Vorwärtsgerichtete Struktur nach Anspruch 1,
**dadurch gekennzeichnet, dass** die Stromquellen, die die zweiten Transistoren des ersten Paars von Transistoren und des zweiten Paars von Transistoren steuern, mit den Kollektoranschlüssen der zweiten Anschlüsse verbunden sind, wobei der Wert der Stromquelle des zweiten Paars von Transistoren dem (1+K)-fachen des Wertes der Stromquelle des ersten Paars von Transistoren entspricht.

7. Zelle mit einer vorwärtsgerichteten Struktur mit programmierbaren Nullstellen,
**dadurch gekennzeichnet, dass** sle aufweist: ein erstes Paar (1, 2) von bipolaren Transistoren und ein zweites Paar (6, 7) von bipolaren Transistoren, die beiderseits mit einem dazwischengeschalteten ersten Hochimpedanzelement (C) verbunden sind, ein zweites Hochimpedanzelement (C), das an dem Ausgang des zweiten Paars von Transistoren bereitgestellt ist, einen weiteren Transistor (4 Fig. 1, 8 Fig. 2), der zwischen einem ersten Transistor des ersten Paars und einem zweiten Transistor des zweiten Paars geschaltet ist.

8. Zelle mit vorwärtsgekoppelter Struktur nach Anspruch 7,
**dadurch gekennzeichnet, dass** in dem weiteren Transistor der Basisanschluss mit dem Kollektoranschluss des ersten Transistors des ersten Paars von Transistoren verbunden ist und der Kollektoranschluss mit dem Kollektoranschluss des zweiten Transistors des zweiten Paars von Transistoren verbunden ist.

9. Zelle mit vorwärtsgekoppelter Struktur nach Anspruch 8,
**dadurch gekennzeichnet, dass** ein von dem Kollektoranschluss des ersten Transistors des ersten Paars von Transistoren abgegriffenes Signal dem Basisanschluss des weiteren Transistors zugeführt wird.

10. Zelle mit vorwärtsgerichteter Struktur nach Anspruch 8,
**dadurch gekennzeichnet, dass** ein Signal, das von dem Kollektoranschluss des ersten Transistors des ersten Paars von Transistoren abgegriffen wird, mit vertauschtem Vorzeichen dem Basisanschluss des weiteren Transistors zugeführt wird.

11. Zelle mit vorwärtsgerichteter Struktur gemäß Anspruch 7,
**dadurch gekennzeichnet, dass** Stromquellen jeweils mit den Kollektoranschlüssen der zweiten Transistoren des ersten und zweiten Paars von Transistoren verbunden sind, wobei der Wert der Stromquelle, die mit dem zweiten Transistor des zweiten Paars verbunden ist, dem (1+K)-fachen des Wertes der Stromquelle entspricht, die mit dem zweiten Transistor des ersten Paars verbunden ist.

12. Zelle mit vorwärtsgekoppelter Struktur nach Anspruch 1,
**dadurch gekennzeichnet, dass** eine Stromquelle mit einem Wert, der dem K-fachen des Wertes der Stromquelle entspricht, die mit dem Kollektoranschluss des zweiten Anschlusses des ersten Paars von Transistoren verbunden ist, mit dem Emitteranschluss des weiteren Transistors verbunden ist.

## Revendications

1. Structure progressive à zéros programmables pour synthétiser des filtres continus, des lignes à retard et analogue, **caractérisée en ce qu'**elle comprend une première cellule (figure 1) et une seconde cellule (figure 2) connectées en cascade, chacune des première et seconde cellules comprenant une première paire (1, 2) de transistors bipolaires dont les bornes d'émetteur sont connectées à une source de courant (5), la première paire de transistors étant connectée à une seconde paire (6, 7) de transistors, une source de courant (11) étant connectée aux bornes d'émetteur de la seconde paire de transistors, un premier élément à haute impédance (C) étant connecté entre les première et seconde paires de transistors, un second élément à haute impédance (C) étant connecté en sortie à la seconde paire de transistors, un cinquième transistor (8) étant connecté entre la borne de collecteur d'un premier transistor (1) de la première paire de transistors et la borne de collecteur d'un second transistor (7) de la seconde paire de transistors, la borne de base du cinquième transistor recevant un signal pris sur la borne de collecteur du premier transistor de la première paire de transistors, le signal étant pris avec un signe positif dans la première cellule et avec un signe négatif dans la seconde cellule, pour déterminer une fonction de transfert avec une paire de singularités au numérateur, les seconds transistors (2, resp.7) des première et seconde paires étant commandés respectivement par des sources de courant (4, resp.9) qui ont des valeurs mutuellement différentes.

2. Structure progressive selon la revendication 1, **caractérisée en ce que** les sources de courant des seconds transistors des première et seconde paires de transistors sont connectées aux bornes de collecteur des seconds transistors.

3. Structure progressive selon la revendication 1, **caractérisée en ce que** les seconds transistors des première et seconde paires de transistors sont connectés en diode.

4. Structure progressive selon la revendication 2, **caractérisée en ce que** la borne d'émetteur du cinquième transistor est connectée à une source de courant.

5. Structure progressive selon la revendication 4, **caractérisée en ce que** la source de courant connectée à la borne d'émetteur du cinquième transistor a une valeur égale à K fois la valeur de la source de courant connectée à la borne de collecteur du second transistor de la première paire de transistors.

6. Structure progressive selon la revendication 1, **caractérisée en ce que** les sources de courant qui commandent les seconds transistors de la première paire de transistors et de la seconde paire de transistors sont connectées aux bornes de collecteur des seconds transistors, la valeur de la source de courant de la seconde paire de transistors étant égale à (1+K) fois la valeur de la source de courant de la première paire de transistors.

7. Cellule à structure progressive ayant des zéros programmables, **caractérisée en ce qu'**elle comprend une première paire (1, 2) de transistors bipolaires et une seconde paire (6, 7) de transistors bipolaires qui sont mutuellement connectées avec interposition d'un premier élément à haute impédance (C), un second élément à haute impédance (C) étant prévu à la sortie de la seconde paire de transistors, un autre transistor (4 fig. 1, 8 fig. 2) étant connecté entre un premier transistor de la première paire et un second transistor de la seconde paire.

8. Cellule à structure progressive selon la revendication 7, **caractérisée en ce que**, dans l'autre transistor, la borne de base est connectée à la borne de collecteur du premier transistor de la première paire de transistors et la borne de collecteur est connectée à la borne de collecteur du second transistor de la seconde paire de transistors.

9. Cellule à structure progressive selon la revendication 8, **caractérisée en ce qu'**un signal pris sur la borne de collecteur du premier transistor de la première paire de transistors est envoyé à la borne de base de l'autre transistor.

10. Cellule à structure progressive selon la revendication 8, **caractérisée en ce qu'**un signal pris sur la borne de collecteur du premier transistor de la première paire de transistors est envoyé, avec son signe changé, à la borne de base de l'autre transistor.

11. Cellule à structure progressive selon la revendication 7, **caractérisée en ce que** les sources de courant sont respectivement connectées aux bornes de collecteur des seconds transistors des première et seconde paires de transistors, la valeur de la source de courant connectée au second transistor de la seconde paire étant égale à (1+K) fois la valeur de la source de courant connectée au second transistor de la première paire.

12. Cellule à structure progressive selon la revendication 1, **caractérisé en ce qu'**une source de courant ayant une valeur qui est égale à K fois la valeur de la source de courant connectée à la borne de collecteur de la seconde borne de la première paire de transistors est connectée à la borne d'émetteur de l'autre transistor.
